Europäisches Patentamt

European Patent Office

Office européen des brevets

(11) Publication number: **0 070 071**
A1

# EUROPEAN PATENT APPLICATION

(21) Application number: 82200839.7

(22) Date of filing: 06.07.82

(51) Int. Cl.³: **H 01 R 9/09**

(30) Priority: 10.07.81 NL 8103303

(43) Date of publication of application:
19.01.83 Bulletin 83/3

(84) Designated Contracting States:
CH DE FR GB LI NL SE

(71) Applicant: N.V. Philips' Gloeilampenfabrieken
Groenewoudseweg 1
NL-5621 BA Eindhoven(NL)

(72) Inventor: Steinmetz, Anthony
c/o INT. OCTROOIBUREAU B.V. Prof. Holstlaan 6
NL-5656 AA Eindhoven(NL)

(72) Inventor: Verweg, Fransiscus G.C.
c/o INT. OCTROOIBUREAU B.V. Prof. Holstlaan 6
NL-5656 AA Eindhoven(NL)

(72) Inventor: Arnold, Jacobus Johannes
c/o INT. OCTROOIBUREAU B.V. Prof. Holstlaan 6
NL-5656 AA Eindhoven(NL)

(72) Inventor: Gerritsen, Frederik Hendrik
c/o INT. OCTROOIBUREAU B.V. Prof. Holstlaan 6
NL-5656 AA Eindhoven(NL)

(74) Representative: Jelmorini, Pius Antonius et al,
INTERNATIONAAL OCTROOIBUREAU B.V. Prof.
Holstlaan 6
NL-5656 AA Eindhoven(NL)

(54) Printed circuit board assembly.

(57) Assembly, comprising at least one or more printed circuit boards electrically connected at printed wiring terminations which are coupled to one or more circuit components by means of a dispersion of electrically conductive particles in a non-conducting plastics binder or in a thermoplastic foil. At least in the region of the particle-loaded binder the interconnected elements are kept in an intimate contact, either by separate means or by means of a curable adhesive as the binder, the adhesive being cured after positioning.

FIG.1

"Printed circuit board assembly"

The invention relates to an assembly comprising at least one printed circuit board electrically connected one at printed wiring terminations by means of coupling means to one or more circuit components.

Known coupling means are <u>inter</u> <u>alia</u> printed circuit conductors on a flexible substrate, connector pairs or unilaterally metallized flexible strips of an insulating plastic material, which all require rather a considerable time to produce and/or to mount.

The said flexible strip is provided with parallel conducting paths each having a width which is less than the conductor spacing of the printed conductors which must be electrically connected by means of the strip.

It is an object of the invention to provide coupling means which can be produced in a rather simple way and which can also be mounted in a rather simple way.

According to the invention, the assembly is characterized in that the coupling means are in the form of a dispersion of electrically conducting particles in a non-conducting paste-like binder or a thermoplastic foil together with means for keeping the printed wiring terminations and electrical connections on the circuit component(s) in secure mutual contact with the electrically conducting particles, or that the coupling means are a cured adhesive in which electrically conducting particles are dispersed and that the electrically conducting particles electrically connect the circuit component(s) to the printed wiring terminations.

The circuit components may be for example a printed circuit board, a liquid crystal display device or leadless components.

The electrically conductive particles must preferably have such a hardness that they are capable of penetrating through an oxide layer on the metal of the wiring terminations. The minimum diameter of the particles must of course be at least as large as the maximum thickness of the oxide layer. When a metal is used which hardly forms oxide on its surface, such as, for example, German silver (Cu-Ni-Zn in a weight ratio 60-18-22) softer particles may be used which are smeared over a portion of the surface, the particles consisting of, for example, Au on Pt. With due observance of this limit it is yet possible to contact very narrow conductor widths and conductor spacings without short-circuiting. The number of particles must be so great that the resistance of the compressed paste-like binder or foil in which the particles are dispersed is sufficiently low in the thickness direction.

The binder in which the particles are dispersed may be a fat, an oil or a wax, for example paraffin, petroleum jelly, bees wax, lanoline etc.

The hard, conducting particles may consist of tungsten, molybdenum, ruthenium, stainless steel, ruthenium oxide, glassy carbon etc. The concentration of the particles in the mixture is approximately 10-50% by weight.

In accordance with an embodiment of the coupling means used within the framework of the invention, the binder consists of a curable adhesive, for example a thermoplastic adhesive of the acrylonitrile-butadiene type, modified with a curable component, such as phenol formaldehyde or an epoxy resin. The adhesive also performs the function of a means for keeping the elements to be bonded in intimate contact with eachother. The adhesive is cured after positioning. This embodiment is particularly interesting for the permanent provision of lead-less components on a printed circuit board. Alternatively, an embodiment is possible wherein hard, conducting particles are dispersed in a thermoplastic foil, consisting for example of polyvinyl chloride.

It should be noted that the UK Patent Specification 363,075 discloses a method of connecting busbars of aluminium, a good electrical contact being ensured. To this end, a similar paste with hard metal particles is previously smeared on the parts to be connected. However, the components used in this Patent Specification are more robust than the parts of the composite body in accordance with the invention, which are used in electronics and where the interconnection of closely spaced conductors is involved, where other prior art techniques used in electronics fail because of difficulties encountered as regards their positioning. For a person skilled in the art these technical fields are so remote from each other that the transfer of a measure from one technical category to the other is certainly not obvious.

In the assembly in accordance with the invention the connecting means provide an excellent protection for the bonded parts. Repeatedly detaching the parts and connecting them again does not affect the protection against corrosion and the contact resistance surprisingly does not increase but even becomes lower.

The embodiments of the invention will now be further described with reference to the accompanying drawings.

Fig. 1 shows an electric connection of two printed circuit boards, and

Fig. 2 shows an assembly of a liquid crystal board which is electrically coupled to a flexible printed circuit foil.

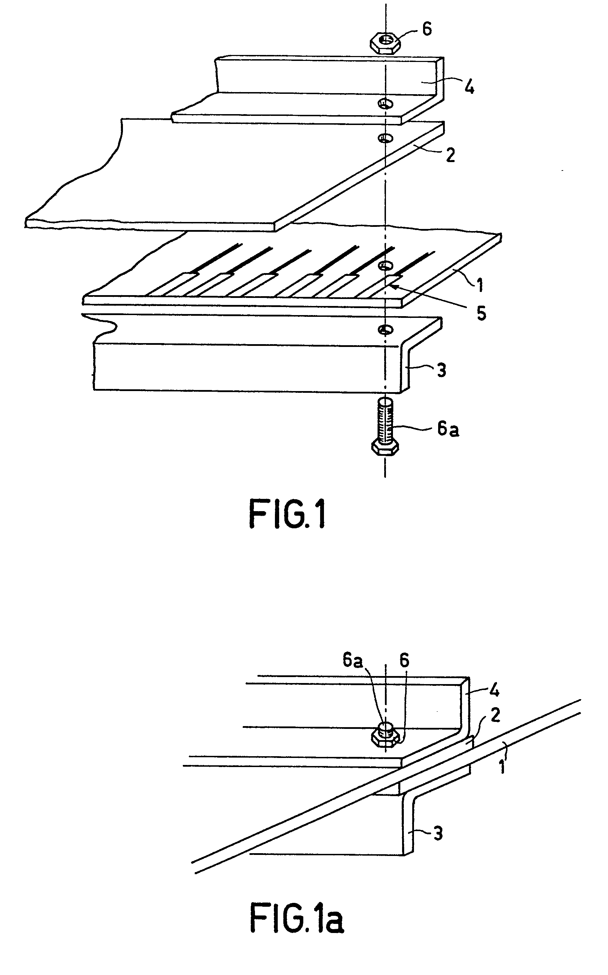

In Fig. 1, reference numerals 1 and 2 denote printed circuit boards. The pattern of the printed circuit has a series of outputs which are provided on one side of the board in the form of parallel strips: that is to say, the series 5 on board 1 and a corresponding series, not shown, at the bottom side of board 2. The two series constitute a number of pairs of printed connectors. The edge areas of the boards on which the conducting strips are provided are coated with a conductive paste in accordance with the invention.

Fig. 1a shows the combination after assembly; The boards are pressed each other by means of supporting strips 3 and 4, secured by nuts 6 engaged with bolts 6a.

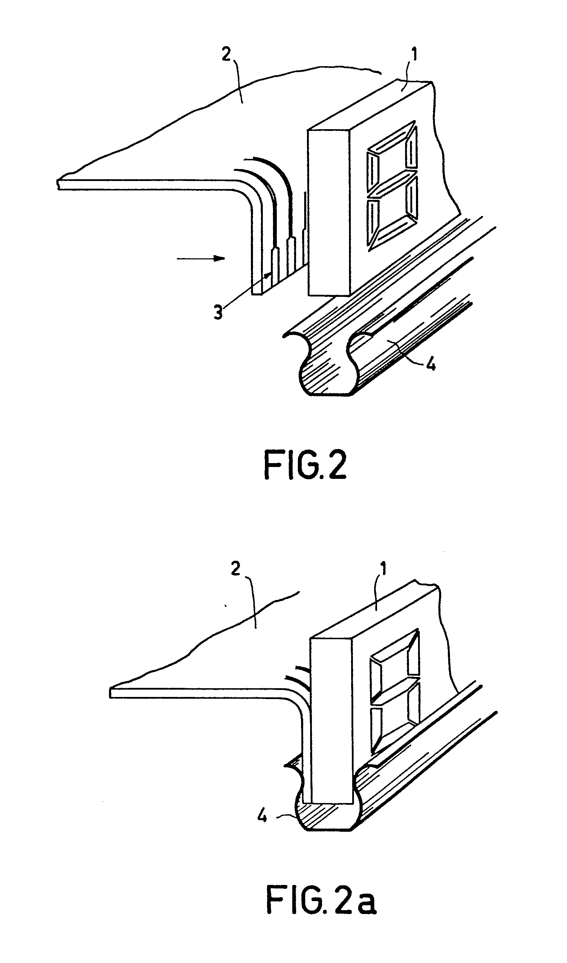

Fig. 2 shows a liquid crystal board 1, the rear side of which is provided with a series of parallel outputs, not shown in this drawing. The flexible printed circuit foil 2 has a corresponding series of parallel outputs 3 of the printed circuit pattern, which is not shown in the drawing. Also in this embodiment the edge areas bearing the conducting strips of the two boards are coated with a conductive paste. Fig. 2 shows how the two parts are kept pressed together by means of a spring 4.

In the region of the electric contact, the interconnected parts of the embodiment shown in Fig. 1 are coated with one of two pastes, which comprised the following components in the ratios mentioned earlier in the description:

a.      1 g of vaseline, in which is dispersed

         0,5 g of ruthenium powder having a particle size of 60 $\mu$m

b.      3 g paraffin which is first dissolved at approximately 90$^{o}$C

in 10 g of white spirit.

The solution is cooled to a temperature at which is forms a jelly-like paste.

Thereafter, 1g of ruthenium powder having a particle size of 60 µm is stirred in the paste until a homogeneous mixture has been obtained.

In the embodiment shown in Fig. 2, similar pastes are used with an equally large concentration of gold powder having a particle size of 40 µm.

The layers are applied by means of a brush or by dipping.

The assemblies in accordance with these two embodiments are heated to and maintained at $100^{O}C$ and the resistance of the assemblies is measured after 24, 72 and 170 hours. The resistance is stable with a tendency to decrease.

Also after a gas test consisting of exposing the bodies for 24 hours to an atmosphere having a content of 1% by volume of $SO_2$ and a relative humidity of 95%, followed by a stay of also 24 hours in an atmosphere having a content of 1% by volume of $H_2S$ with a relative humidity of 95% a hardly measurable increase of the resistance had occured.

CLAIMS

CLAIMS

1.         An assembly comprising at least one printed circuit board electrically connected at printed wiring terminations by means of coupling means to one or more circuit components, characterized in that the coupling means are in the form of a dispersion of electrically conducting particles in a non-conductive paste-like binder or a thermoplastic foil together with means for keeping the printed wiring terminations and electrical connections on the circuit component(s) in secured mutual contact with the electrically conducting particles, or that the coupling means are a cured adhesive in which electrically conducting particles are dispersed, and that the electrically conducting particles electrically connect the circuit component(s) to the printed wiring terminations.

2.         An assembly as claimed in Claim 1, characterized in that the electrically conducting particles have such a hardness that they are capable of penetrating through an oxide layer on the metal of the wire terminations.

3.         An assembly as claimed in Claim 1 or Claim 2, characterized in that the binder consists of a curable adhesive which is cured after positioning.

FIG.1

FIG.1a

0070071

FIG.2

FIG.2a

European Patent
Office

**EUROPEAN SEARCH REPORT**

Application number

EP 82 20 0839

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| E | EP-A-0 036 226 (PHILIPS) * Claims * & NL - A - 80 01555 (14-10-1981) | 1,2 | H 01 R 9/09 |
| X,Y | US-A-4 113 981 (SEIKOSHA) * Column 2, line 68 - column 4, line 10; figures * & NL - A - 75 09591 | 3 | |
| Y | US-A-3 157 735 (P.T. STROUP) * Column 5, line 41 - column 6, line 46; figures * | 1-3 | |
| A,D | GB-A- 363 075 (VEREINIGTE ALU-WERKE) * Whole document * & DE - C - 528 059 | 2 | |
| A | GB-A-1 161 730 (NATIONAL CASH REGISTER) * Page 1, lines 22-39; figures * | 1 | |

TECHNICAL FIELDS SEARCHED (Int. Cl. ³)

H 01 R 13
H 01 R 4
H 01 R 9
H 05 K 3

The present search report has been drawn up for all claims

| Place of search | Date of completion of the search | Examiner |
|---|---|---|
| THE HAGUE | 27-10-1982 | RAMBOER P. |

EPO Form 1503 03.82

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document